# EUROPEAN PATENT SPECIFICATION

(11) **EP 1 894 203 B1**
(45) Date of publication and mention of the grant of the patent: **07.09.2011**
(21) Application number: 06747667.1
(22) Date of filing: 08.06.2006
(51) Int. Cl.: G11C 11/22, H01L 51/40, H05K 3/12

(54) **A METHOD IN THE FABRICATION OF A FERROELECTRIC MEMORY DEVICE**
VERFAHREN BEI DER HERSTELLUNG EINES FERROELEKTRISCHEN SPEICHERBAUSTEINS
PROCÉDÉ DE FABRICATION DE DISPOSITIF DE MÉMOIRE FERROÉLECTRIQUE

(30) Priority: 14.06.2005 NO 20052878
(43) Date of publication of application: 05.03.2008
(73) Proprietor: Thin Film Electronics ASA, N-0124 Oslo (NO)
(72) Inventor: DYREKLEV, Peter, S-582 46 Linköping (SE); LEISTAD, Geirr, I., N-1337 Sandvika (NO); GUSTAFSSON, Göran, S-582 16 Linköping (SE)
(74) Representative: Bokinge, Ole
(86) International application number: PCT/NO2006/000215
(87) International publication number: WO 2006/135246

(56) References cited:
- WO-A-02/43071
- WO-A-03/107351
- US-A1- 2003 001 176
- US-A1- 2003 215 565
- US-A1- 2003 230 746
- US-A1- 2004 014 247
- US-B1- 6 686 211

## Description

The present inventions concerns a method in the fabrication of a ferroelectric memory device, wherein the memory device comprises a array of ferroelectric memory cell defined in a patterned or unpatterned layer of a thin film of a ferroelectric polymer, and first and second electrode sets such provided contacting the ferroelectric layer of opposite sides thereof, such that the ferroelectric memory cell is defined in the memory material between the crossing of an electrode of the first set with an electrode of the second set whereby a polarization state of the memory cell can be set, a set polarization states switched and detected by applying appropriate voltages to the electrodes contacting the memory cell, and wherein the memory device is provided on an insulating substrate.

Over the past years there has been a growing demand for cheap and flexible tags and labels in which information can be stored, for example as anti-counterfeiting tags in packaging or as identification tags. Production of such a memory device should be cheap and easy to incorporate in the package printing process or the packaging process and should consist of uncomplicated and cheap materials and involve a minimum of processing steps. For use in packages, it is important that the memory device is relatively robust and insensitive to mechanical shock, temperature changes and other environmental influences. In numerous applications, it is important that the information stored in the memory device can be electrically written, read, erased and rewritten.

One type of memory cells that has proven to be rewritable and bistable over prolonged periods of time is based on ferroelectric memory materials. Although an extensive literature exists on ferroelectric-based memory devices, much of this is related to ceramic ferroelectric films and/or semiconductor substrates that require high temperature processing steps and typically are too costly or impractical for the range of applications of interest here. Thus, US patent application 2004/0,209,420A1 describes a method for making a ferroelectric memory cell in which the electrodes are metallic. The method relies on the evaporation of metals at high temperatures and in vacuum. In addition, the substrate is limited to silicon wafers. The production processes for the ferroelectric memory cells disclosed in US patent application 2004/0,209,420A1, International published applications WO 98/58383 and WO 02/43071 all rely on evaporation and etching methods to apply the metal or silicon structures, requiring high temperatures in the range of 300°C to 400°C, which results in melting or severe degradation of polymer-based or paper-based substrates, hence making it unsuitable for packaging.

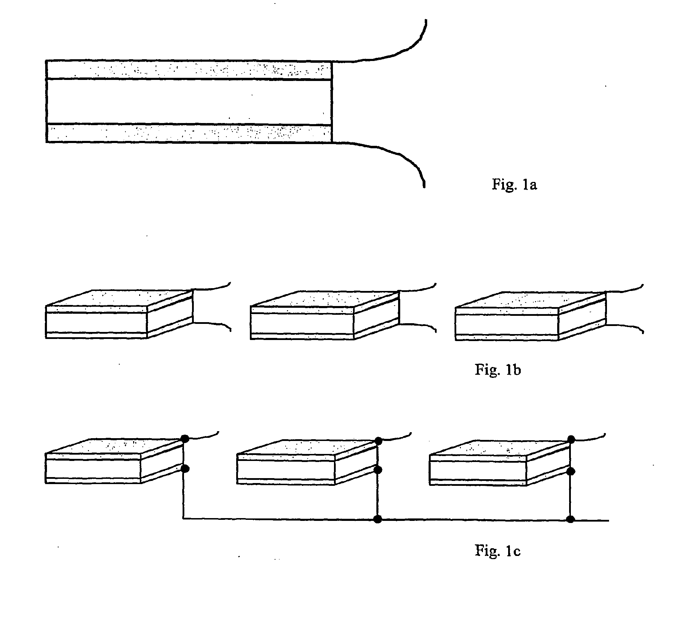

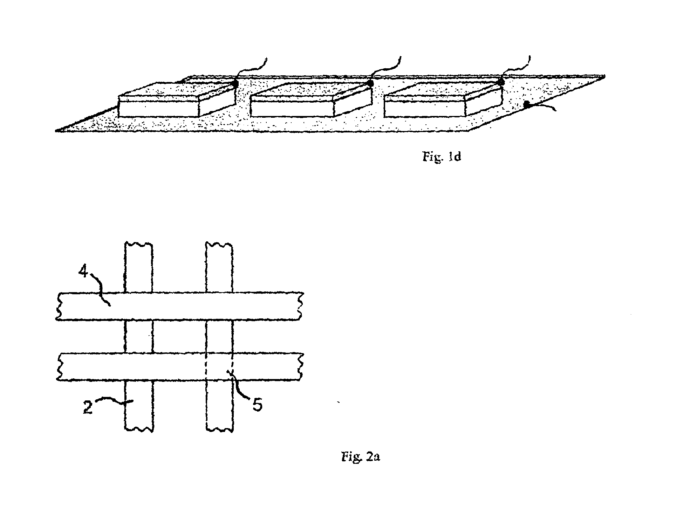

During recent years, memory structures and devices based on organic materials as the memory substance, in particular ferroelectric polymers, have been proposed and demonstrated. Of particular interest in the present context are those that can be built on flexible substrates and that lend themselves well to simple and high volume manufacturing processes. Typically, this concerns purely passive tags or devices where active electronic components are not required in the memory structure itself. Each memory cell is a capacitor-like structure where the memory substance, e.g. a ferroelectric polymer is located between a pair of electrodes and where the memory cell is accessed via conductors linking the electrodes to electronic driver or detection circuitry. The latter may e.g. be located on the periphery of the memory array or on a separate module. Depending on the application, each tag or device may contain from one individual memory cell and up to several millions of cells arranged in matrix arrays. Some basic cell architectures and array arrangements that are of relevance here are shown in Figs. 1-3.

Manufacturing issues are of decisive importance in applications where low cost tags are to be made in very high volumes. In the existing literature on organic-based memory devices there has been little focus on printing technologies for creating electrical structures such as interconnect wiring and cell electrodes.

US patent application 2003/0,230,746A1 discloses a memory device comprising a first semiconducting polymer film having a first side and a second side, wherein said first semiconducting polymer film includes an organic dopant; a first plurality of electrical conductors substantially parallel to each other coupled to said first side of said first semiconducting polymer layer; and a second plurality of electrical conductors substantially parallel to each other, coupled to said second side of said first semiconducting polymer layer and substantially mutually orthogonal to said first plurality of electrical conductors, wherein an electrical charge is localized on said organic dopant. It is claimed that the first plurality of electrical conductors, that is the first conducting patterns can be inkjet printed, but no other printing techniques are stated. In addition, the described memory device uses a semiconducting polymer layer including a dopant and writing of information via an electrical charge localized on the dopant and the memory device is volatile; the information is lost if no power is applied.

International published patent application WO 02/29706A1 discloses an electronic bar code comprising: a bar code circuit that stores a code that is electronically readable, wherein the code is defined by a polymer printing process; and an interface coupled to the bar code circuit to allow a bar code reader to access the code stored in the bar code circuit. Although this is a printed memory, the printed electronic circuit is not based on ferroelectric materials nor is it rewritable.

Organic electronics fabricated by printing methods have been reported in the literature by many researchers and companies. The majority describes devices where semiconducting properties of the organic materials are used to realise the device function. Printing of all-polymer field effect transistors have been published by Garnier & al. [Garnier, F., R. Hajlaoui, et al., "All-polymer field-effect transistor realized by printing techniques", Science, Vol. 265, pp. 1684-1686 (1994)]. In this paper they describe how a field effect transistor is fabricated by printing of organic conducting and semiconducting materials. Furthermore they claim that such a device could be made using different conducting polymers such as polyaniline, polypyrrole and polythiophene. The authors write "A field-effect transistor has been fabricated from polymer materials by printing techniques. The device characteristics, which show high current output, are insensitive to mechanical treatments such as bending or twisting. This all-organic flexible device realized with mild techniques, opens the way for large-area, low-cost plastic electronics." The technique used for printing in this paper seems to be far away from conventional high volume printing methods, but still the materials are deposited by a method not common for micro-electronics manufacturing.

The use of more established printing methods is e.g. reported by Hebner & al. [Hebner & al., "Ink-jet printing of doped polymers for organic light emitting devices", Applied Physics Letters 72(5), pp. 519-521(1998)]. The authors claim "Ink-jet printing was used to directly deposit patterned luminescent doped-polymer films. The luminescence of polyvinylcarbazol (PVK) films, with dyes of coumarin 6(C6), coumarin 47(C47), and nile red was similar to that of films of the same composition deposited by spin coating. Light emitting diodes with low turn-on voltages were also fabricated in PVK doped with C6 deposited by ink-jet printing." Dyed organic polymer was printed to form features in size the range 150-200 µm and having a thickness of 40-70 nm. In the reported work only the active emissive layer is printed while the metallic electrodes are deposited by physical vapour deposition.

Other devices that are fabricated by printing methods are reported by Andersson & al. in a paper entitled "Active Matrix Displays Based on All-Organic Electrochemical Smart Pixels Printed on Paper" [P. Andersson, & al., "Active Matrix Displays Based on All-Organic Electrochemical Smart Pixels Printed on Paper", Adv. Materials 14(20), pp. 1460-1464 (2002)]. There the authors have printed conducting polymer structures to form both transistors, resistors as well as display elements. The printed layers are PEDOT:PSS formed by either additive printing or subtractive patterning.

Printing of PEDOT:PSS has also been used for making the transducer for a humidity sensor. This was reported by Nilsson & al. [D.Nilsson, & al., "An all-organic sensor-transistor based on a novel electrochemical transducer concept printed electrochemical sensors on paper." Sensors and Actuators, B 86, pp. 193-197, (2002)].

Another method of utilising printing technology for the manufacturing of an electronic device is reported by Huang et al. [Z. Huang & al., "Selective deposition of conducting polymers on hydroxyl-terminated surfaces with printed monolayers of alkylsiloxanes as templates." Langmuir, Vol.13, pp. 6480-6484 (1997)]. Self-assembled monolayers are printed to be used as templates for the deposition of conducting polymer microstructures. i.e. the conducting polymer itself is not printed.

US patent No. 6,686,211 (Asakawa, assigned to Seiko Epson Corp.) discloses a ferroelectric memory device of the 1T-1C type. Ink-jet printing is used for depositing an organic ferroelectric thin film and the top electrode of the ferroelectric capacitor.

Further US patent application No. 2004/0014247A1 (Natori & al., assigned to Seiko Epson Corp.) concerns a passive matrix-addressable ferroelectric memory array wherein the ferroelectric material, which is of the ceramic inorganic type, can be deposited by ink-jet printing and then patterned.

Finally, US patent application No. 2002/0142491A1 (Shimoda 6 al., assigned to Seiko Epson Corp.) concerns improvements in the fabrication of a semiconductor memory of the FeRAM type, wherein the ferroelectric memory material and the top electrode of the ferroelectric capacitor can be printed with ink-jet printing.

It appears that the prior art in regard of printing of ferroeletric memories is limited to depositing the ferroelectric material by ink-jet printing whereby an instant discretization of the dielectric of the ferroelectric capacitor can be provided. In some cases the ink-jet printing of the ferroeletric material is combined with patterning by means of photolithograhic and etching processes, which would effectively nullify any advantage of printing the ferroelectric material itself. In any case, the different methods for respectively depositing and patterning required in the fabrication of ferroelectric memories as disclosed in the in prior art, make the fabrication more costly and complicated and are moreover also difficult to implement in high-volume production lines.

There is therefore a need for an easy and inexpensive method of making a rewritable non-volatile memory device which can be easily incorporated in a tag, label or package printing process or the packaging process itself. Moreover, such easy and inexpensive means of storing information must be capable of lending itself to environmentally friendly disposal.

It is a primary object of the present invention to provide methods for low-cost, high volume manufacturing of memory devices, by deposition of patterned thin films of conducting material and/or organic memory material, in particular ferroelectric polymer, on a range of substrates that include, but are not limited to, tags, labels and packaging materials in rigid or flexible form.

It is a further object of the present invention to provide materials suitable for such deposition.

The above objects as well as further features and advantages are realized with a method according to the invention which is characterized by comprising successive steps for a) applying a first printing means to the substrate for printing a first electrode layer thereon with a first printing ink, whereby the first set of electrodes is formed, b) applying to a second printing means to the first electrode layer and printing a patterned or unpatterned layer of memory material thereon with a second printing ink, and c) applying a third printing means to the memory layer for printing a second electrode layer thereon with a third printing ink, whereby the second set of electrodes is formed, and whereby the printing in one or more of the steps a), b) and c) is performed by ink-jet printing, intaglion printing, screen printing, flexogram printing, offset printing, stamp printing, gravure printing, electrographic printing, soft lithography, wax-jet printing, or any thermal or laser-induced printing process, either separately or in combination.

Further features and advantages will be apparent from the appended dependent claims.

Either one printing process can be used for all the patterns or layers in the memory device, or a combination of two or more different printing processes can be used.

In order to be able to print at high speeds, drying times of all the printed patterns or layers have to be as short as possible. It is therefor another aspect of this invention to use printing inks for the conducting electrode patterns and for the ferroelectric polymer layer or pattern which can be dried in a very short time, allowing the printing of the memory devices at high speeds. In addition, there are several other physical and chemical requirements that must be fulfilled by the materials to be printed in order to provide a viable industrial scale printing process.

The memory devices may be printed directly on packaging material prior to or after the packaging process. Alternatively, memory devices are printed on labels or tags that are affixed to the package.

The invention shall be described in more detail in the following in connection with discussions of exemplary embodiments and examples, with reference to the appended drawing figures in which
fig. 1a shows the generic structure of a single memory cell,
figs. 1b-d show examples of arrayed cells,
figs. 2a-b show a passive matrix addressed array of cells, and
fig. 3 shows a stacked array of passive matrix addressed cells.

Below follow some definitions relevant for the understanding of the detailed discussion of the present invention.

The term "support", as used in disclosing the present invention, means a "self-supporting material" so as to distinguish it from a "layer" which may be coated on a support, but which is itself not self-supporting. It also includes any treatment necessary for, or layer applied to aid adhesion to layers or patterns which are printed on the support.

The term "pattern", as used in disclosing the present invention, means a non-continuous layer which can be in any form of lines, squares, circles or any random configuration.

The term "layer", as used in disclosing the present invention, means a coating covering the whole area of the entity referred to e.g. a support.

The term "conventional printing processes", as used in disclosing the present invention, includes but is not restricted to ink-jet printing, intaglio printing, screen printing, flexographic printing, offset printing, stamp printing, gravure printing and thermal and laser-induced processes.

The term "conductive polymer", as used in disclosing the present invention, means organic polymers which have (poly)-conjugated π-electron systems (e.g. double bonds, aromatic or heteroaromatic rings or triple bonds) and whose conductive properties are not influenced by environmental factors such as relative humidity.

The term "transparent", as used in disclosing the present invention, means having the property of transmitting at least 70% of the incident light without diffusing it.

The term "flexible", as used in disclosing the present invention, means capable of following the curvature of a curved object such as a drum e.g. without being damaged.

PEDOT, as used in disclosing the present invention, represents poly(3,4-ethylenedioxythiophene).

PSS, as used in disclosing the present invention, represents poly(styrene sulfonic acid) or poly(styrene sulfonate).

As an aid to understanding the present invention, there shall now be given a brief description of some representative memory cell structures and configurations that are of particular relevance since they lend themselves well to being manufactured with the aid of the present invention.

The memory cells in question consist of a pair of electrodes contiguous to a volume of an electrically polarizable memory substance, typically in the form of a ferroelectric polymer, and typically in a parallel-plate capacitor-like structure, cf. fig. 1a. This simple structure is in strong contrast to memory cells in traditional memory technologies, where one or more transistors or other semiconducting elements are required in association with each cell, and the consequences for low cost manufacturing are dramatic. In the following, memory devices based on the simple structure referred above shall be referred to as a "passive memory device".

A plurality of memory cells may be arranged side by side on a common substrate, each cell having the generic structure shown in fig. 1a, where electrical access to each cell is by wire connection to each of the two electrodes. Depending on the application, the size, shape, spatial distribution, and electrical connection arrangement for a plurality of memory cells may vary; some examples are shown in figs. 1 b-d. Fig. 1b shows an array of individual cells, each of which has a wire connection to the two electrodes. Further electrical connections to the wires may take many forms, e.g. ending in contact pads on a common substrate. Fig. 1c shows a similar arrangement, but where all bottom electrodes are electrically connected in order to reduce wiring complexity. Fig. 1d is a variant where a plurality of cells are arranged on a conducting surface which forms a common bottom electrode in each cell, and where each cell has its own, individually electrically connected top electrode. This arrangement is similar to that shown in fig. 1c in that it requires less connecting electrodes than that of fig. 1b.

Substrates shall in the present context typically be flexible, although this may not always be the case. They may be electrically insulating, e.g. in the form of a sheet of paper, a plastic foil, glass, board, carton or a composite material of any of these materials. Alternatively, they may be electrically conducting, e.g. in the form of a metal foil with an insulating coating to avoid electrical short circuits. The arrayed memory cells on a given substrate may be electrically accessed from external circuitry by means of mechanical contacts pads on the substrate. Alternatively, there may be active electrical circuitry incorporated on or in the substrate itself. If the latter is flexible, the circuitry shall typically be located in thin film semiconducting material based on silicon (amorphous or polycrystalline) or organic materials (polymers or oligomers).

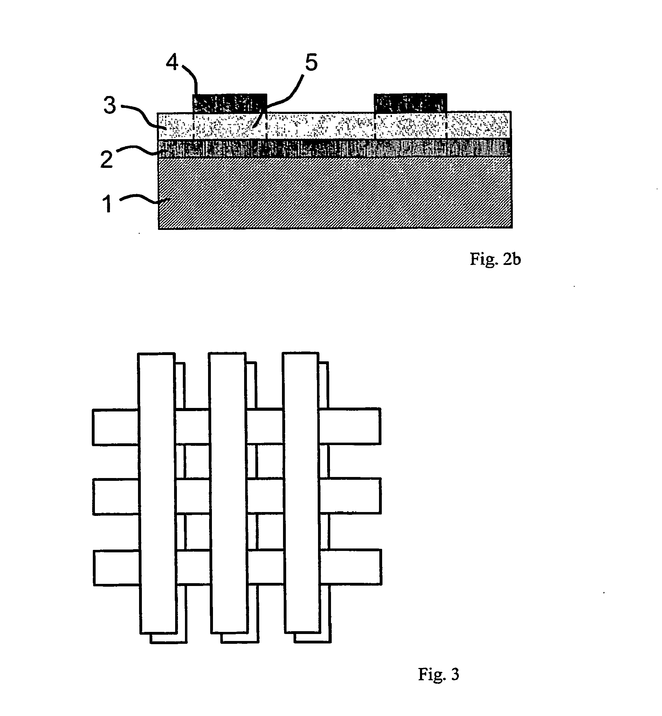

In cases where large numbers of memory cells are involved, a matrix-addressable array of memory cells as shown in figs. 2a-b provides a simple and compact means of providing electrical access to individual cells for writing, reading, and erasing operations. This memory device configuration is termed a passive matrix device since there are no switching transistors present for switching a memory cell on and off in an addressing operation. Basically a memory device of this kind is formed with a first pattern of parallel strip-like electrodes 2, which is located on a substrate 1 and covered by a global layer of ferroelectric memory material 3, i.e. a ferroelectric polymer, over which are provided another electrode pattern 4 comprising likewise parallel strip-like electrodes, but oriented orthogonally to the first electrode pattern, so as to form an orthogonal electrode matrix. The ferroelectric memory material may also be applied as a non-continuous layer, i.e. a pattern. The first electrode pattern can e.g. be regarded as the word lines of a matrix-addressable memory device, while the second electrode pattern can be regarded as the bit lines thereof. At the crossings between the word lines and bit lines, a memory cell 5 is defined in the matrix in the layer of memory material. Thus the memory device will comprise a plurality of memory cells corresponding to the number of electrode crossings in the matrix.

An interesting aspect of the basic structures described above is that they provide opportunities for stacking of memory arrays on top of each other, cf. fig. 3. This means that very high volumetric data storage densities can be achieved, and large total data storage capacities can be realized on a small footprint and in a small volume.

The electrodes may be a conducting or semiconducting material, which generally can be applied from solid or liquid phase by a wide range of physical and chemical means. Conductive and semiconductive materials can be suspended or dissolved to form inks, e.g. based on conductive metals (e.g. silver paste), conductive metal alloys, conductive metal oxides, carbon black, semiconductive metal oxides and intrinsically conductive organic polymers (e.g. polyaniline, PEDOT).

The memory material in the memory cells may typically be an organic ferroelectric material, e.g. fluorine-containing polymers such as polyvinylidene fluoride (PVDF) or copolymers such as poly(vinylidene fluoride-trifluoroethylene) (PVDF-TrFE). Other examples are polymers with strongly polarizable end groups such as polyvinylidene cyanide (PVCN). Optimization of materials can take place using copolymers, terpolymers and blends (e.g. with polymethylmetacrylate PMMA).

According to the present invention both the electrode layers, i.e. the patterned electrode structures thereof, as well as the ferroelectric memory layer are according to the present invention realized with a conventional printing process, including but not restricted to ink-jet printing, intaglio printing, screen printing, flexographic printing, offset printing, stamp printing, gravure printing and thermal and laser-induced processes. Either one printing process can be used for all the patterns or layers in the memory device, or a combination of two or more different printing processes can be used.

The minimum dimensions of the printed patterns are limited by the printing process chosen, involving both minimum dimensions of printed features, the minimum distance between printed features and the positioning of subsequent patterns or layers on top of the previous printed patterns, in register printing. The minimum practical dimensions are also determined by the electronic control unit for the writing and readout of information. Writing and readout of the information is done by bringing the memory device in contact with an appropriate electronic control unit for driving and detecting the state of the memory cells. To facilitate the positioning of the memory device on the electronic control unit, contact pads need to be sufficiently large and separated by a significant distance to minimize the misalignment of the memory device on the electronic control unit.

In the manufacturing of memory devices according to the present invention, it is a requirement that the printed electrically conducting material used in electrodes, interconnecting wiring, pads etc shall conform with standard physical and chemical requirements for achieving printability. This shall depend on the printing process chosen in each case, but generally includes rheological, solubility and wetting properties, as well as issues concerning cost, toxicity, etc. Drying properties, in particular the volatility of solvents used, shall in large measure influence the attainable speed in the manufacturing process. The latter is of paramount importance in high volume processes, e.g. in the production of ultra low cost tags and labels.

Now follow more detailed examples of preferred embodiments according to the present invention.

### Example 1

In a first embodiment, the method for fabrication of a ferroelectric memory device comprise the following manufacturing steps.

A substrate is prepared for carrying the layers of the memory device. A silicon wafer, 200 mm diameter, is covered with an insulating polymer layer. In this embodiment the insulating base layer is formed by spin coating of polyvinylidene fluoride-trifluoroethylene (PVDF-TrFe) from an organic solvent solution. The layer thickness is thermally annealed at 120°C for 20 min in a convection oven. On the so formed substrate the first electrode layer is deposited.

A conducting polymer liquid containing a suspension of PEDOT-PSS (polyethylenedioxythiophene - polystyrenesulphonate) in water is deposited by ink-jet printing on the substrate surface. The ink-jet printing is done with a printhead manufactured by Xaarjet AB. The printing resolution is 200 dpi and the printing speed is 0.1 m/s. A bottom electrode pattern with smallest feature size 170 um is formed. After the printing, the bottom electrode layer is annealed on a hot plate at 100°C for 2 minutes.

On top of the first electrode layer the ferroelectric polymer layer is printed. The polymer is a polyvinylidene fluoride-trifluoroethylene (PVDF-TrFe) copolymer. It is dissolved in ethyl lactate at the concentration 1.07 g per 100 ml solvent. The solution is stirred until all polymer is dissolved. Then the solution is filtrated through a 0.45 µm pore size filter. The resulting polymer solution has the viscosity 10 mPas, which is suitable for ink-jet printing. The polymer solution is printed onto the substrate carrying the first electrode. An ink-jet printing head from Xaarjet AB is used for the printing. The printing speed is 0.1 m/s and the printed resolution is 200 dpi. After printing one layer it is dried at 100°C for 15 seconds to evaporate solvent. Then a second layer of ferroelectric polymer, identical to the first ferroelectric polymer, is printed and exposed to the same drying process again. A total thickness of 110 nm was deposited by this method.

On the so formed ferroelectric film a second electrode layer is deposited. This layer will serve as the top electrode layer in the ferroelectric device.

A conducting polymer liquid containing a suspension of PEDOT-PSS in water is deposited by ink-jet printing on the substrate surface. The ink-jet printing is done with a printhead manufactured by Xaarjet AB. The printing resolution is 200 dpi and the printing speed is 0.1 m/s. A bottom electrode pattern with smallest feature size 170 µm is formed. After the printing, the bottom electrode layer is annealed on a hot plate at 100°C for 2 minutes.

The resulting ferroelectric device is annealed in a convection oven for 20 minutes at the temperature 120°C.

### Example 2

In a second embodiment the first two layers (bottom electrode and ferroelectric memory layer) are fabricated according to the method described in Example 1. The top electrode layer is in the present embodiment deposited by a different ink-jet printing method and contains a different conducting polymer material. An office ink-jet printer, HP deskjet 980 cxi, is used for printing the top electrode, where original printing ink of the printer is replaced by the conducting polymer liquid. In this embodiment the conducting polymer liquid is a commercially available polyaniline formulation sold by Panipol Oy under the name Panipol-W. It contains polyaniline and a counter ion rendering the compound material a high electrical conductivity, but still being solution processable. A top electrode pattern is printed with the following ink formulation:
- Panipol W (∼10% solution) 10 gram
- PSSH (5% solution) 5 gram
- Surfactant Zonyl FS-300 (30% solution) 0.4 gram
- Deionized water 15 gram

A drying process is applied to the film after printing, it is done at 100°C for 30 min in a convection oven. The printed pattern contains top electrode dots with diameter 0.5 mm.

### Example 3

In a third embodiment of the invention the ferroelectric film is deposited by flexoprinting. The bottom and top electrode layers were fabricated by the method described in Example 1 above. After the bottom electrode process, the substrate is ready for deposition of the ferroelectric polymer memory material. The ferroelectric memory material consisting of the copolymer polyvinylidene fluoride-trifluoroethylene (PVDF-TrFe), with a molar ratio 75:25 for the VDF:TrFe monomers, is dissolved in propyleneglycolmonomethyletheracetate (PGMEA).

The concentration of the dissolved copolymer is 10g per 100 ml solvent. The solution is stirred until all polymer is dissolved. A flexographic proofing tool is used for printing the ferroelectric material. The tool is an RK ESIPROOF hand-held tool supplied from RK Print Coat Instruments Ltd. A polymer layer is printed on the substrate using an anilox roller with cell size corresponding to 9 µm wet thickness. The polymer solution is applied on top of the anilox roller and is, after doctor blading, transferred to a rubber roller when it is rolled over the substrate surface. The viscous ink is placed above the doctor blade at the anilox roller, and the roll is wetted by rolling it over an A4 plastic transparent sheet, then directly after that rolled over the substrate carrying the bottom electrode. Thereby the rubber roller transfer a thin polymer film to the substrate. The resulting polymer film is annealed on a convection oven at 135°C for 5 min. A top electrode is according to the method described in Example 1 above. The so formed device constitutes a printed ferroelectric memory device.

### Example 4

In a fourth embodiment the ferroelectric layer is deposited by spray coating. The first step, fabrication of the bottom electrode, in this embodiment is done according to the method described in embodiment 1. After that process, the substrate is ready for deposition of the ferroelectric polymer memory material. The ferroelectric memory material, consisting of the copolymer polyvinylidene fluoride-trifluoroethylene (PVDF-TrFe), with a molar ratio 70:30 for the VDF:TrFe monomers, is dissolved in propyleneglycolmonomethyletheracetate (PGMEA). The concentration of the dissolved copolymer is 1g per 100 ml solvent. The solution is stirred until all solid polymer is dissolved. Then the solution is filtrated through a 0.45 µm pore size filter. The polymer solution is sprayed onto the bottom electrode surface using a nitrogen powered air-brush spray coating tool ("Clas Ohlson, model 30-6070"). The nitrogen pressure is set to 3 bar. Repeated coating cycles yield a thin wet layer which then is allowed to dry on a hot plate at 50°C for 30 s. The average dry film thickness is approximately 650Å, with a min-max range 550-790 Å. In order to fully dry the film from solvent and increase the crystallinity, the resulting structure is annealed in a convection oven for 20 min at the temperature 120°C.

A top electrode is according to the method described in embodiment 1 above. The so formed device constitutes a printed ferroelectric memory device.

### Example 5

In a fifth embodiment the ferroelectric layer is deposited by a coating method. The first step, fabrication of the bottom electrode, in this embodiment is done according to the method described in embodiment 1. After that process, the substrate is ready for deposition of the ferroelectric polymer memory material. The ferroelectric memory material consisting of the copolymer polyvinylidene fluoride-trifluoroethylene (PVDF-TrFe), with a molar ratio 70:30 for the VDF:TrFe monomers, is dissolved in propyleneglycolmonomethyletheracetate (PGMEA). The concentration of the dissolved copolymer is 5g per 100 ml solvent. The solution is stirred until all polymer is dissolved. Then the solution is filtrated through a 0.45 µm or smaller pore size filter. A thin polymer film is made on the substrate surface by a coating method. The coating method utilizes a bar around which a thin wire is wound in order to create a controlled wet thickness of a solution spread on a surface. Such a coating bar is commercially available from R.K. Print Coating Ltd. Under the trade name K Bar. The polymer solution is dispensed onto the substrate surface and then the coating bar is slided along the surface, pushing the liquid forward and leaving a well controlled homogeneous wet film behind the bar. The thickness of the wet film is controlled by the diameter of the wire on the coating bar. A coating bar for 6 cm³/m² wet thickness is used in this embodiment. The coating bar is moved along the substrate surface with the approximate speed 0.5 m/s. The resulting polymer film is dried in ambient air, and subsequently annealed in a convection oven for 20 minutes at the temperature 120°C. A top electrode is made according to the method described in embodiment 1 above. The so formed device constitutes a printed ferroelectric memory device.

As persons skilled in the art easily will realize, the present invention provides a method for fabricating particularly passive matrix-addressable ferroelectric memory devices in a manner that is a radical departure from the conventional methods based on a combination of photomicrolithography and patterning by etching for the electrode structure, while a thin film of an organic ferroelectric material usually is deposited by spin coating. In this conventional process particularly the deposition and patterning of the top electrodes on the already deposited organic ferroelectric memory layer have proved rather difficult, particularly due to the detrimental effect on the memory layer due to the process used for providing the top electrodes. As the present invention wholly is based on realizing a ferroelectric memory devices of this kind by means of printing processes, the incompatibility between processes and structural materials is avoided. Printing as performed according to the present invention has turned out to be a very flexible method, offering the opportunity for using a wide range of suitable materials. Moreover printing is equally well-suited for depositing global layers as for providing patterning for selected layers, e.g. the electrode layers. Advantageously, printing can be applied on a large as well as a small scale and is capable of providing a large area patterning in a continuous or once-through operation. This is easily combined with a similar, large scalable application of global layers. On the other hand the present invention allows for the simultaneous printing of small-scale features and hence can be applied to the mass-production of either single memory circuits or a plurality of small-scale ferroelectric memories in one and the same operation. Hence in every aspect the method according to the present invention provides for a less costly and much simplified fabrication of ferroelectric memories as compared with the more conventional present-day methods.

## Claims

1. A method in the fabrication of a ferroelectric memory device, wherein the memory device comprises an array of ferroelectric memory cells defined in a patterned or unpatterned layer of a thin film of a ferroelectric polymer, and first and second electrode sets such provided contacting the ferroelectric layer of opposite sides thereof, such that the ferroelectric memory cell is defined in the memory material between the crossing of an electrode of the first set with an electrode of the second set whereby a polarization state of the memory cell can be set, a set polarization states switched and detected by applying appropriate voltages to the electrodes contacting the memory cell, wherein the memory device is provided on an insulating substrate, and wherein the method is **characterized by** comprising successive steps for
a) applying a first printing means to the substrate for printing a first electrode layer thereon with a first printing ink, whereby the first electrode set is formed,
b) applying a second printing means to the first electrode layer and printing a patterned or unpatterned layer of memory material thereon with a second printing ink, **a**nd
c) applying a third printing means to the memory layer for printing a patterned second electrode layer thereon with a third printing ink, whereby the second electrode set formed, and whereby the printing in one or more of the steps a), b) and c) is performed by ink-jet printing, intaglion printing, screen printing, flexogram printing, offset printing, stamp printing, gravure printing, electrographic printing, soft lithography, wax-jet printing, or any thermal or laser-Induced printing process, either separately or in combination.

2. A method according to claim 1,
**characterized by** using the same printing means in two or more of the steps a)-c).

3. A method according to claim 1,
**characterized by** using different printing means in each of the steps a)-c).

4. A method according to claim 1,
**characterized by** applying identical printing inks as the first and third printing ink.

5. A method according to claim 1,
**characterized by** selecting the printing inks according to a chosen printing method.

6. A method according to claim 1,
**characterized by** applying the printing ink either to the surface to be printed or to the printing means before, during, or after the application of the printing means to said surface, the application sequence being dependent on a chosen printing method.

7. A method according to claim 1,
**characterized by** the first and third printing inks comprising a conducting material.

8. A method according to claim 7,
**characterized in** selecting the conducting material as inorganic conducting material.

9. A method according to claim 7,
**characterized in** selecting the conducting material as a conducting organic material.

10. A method according to claim 9,
**characterized** selecting the conducting organic material as a conducting polymer.

11. A method according to claim 10,
**characterized by** selecting the conducting polymer as one of polypyrrole (PPy) derivatives of polypyrrole, polyaniline, derivatives of polyaniline, polythiophenes and derivatives of polythiophenes, either separately or in combination.

12. A method according to claim 11,
**characterized by** selecting as derivate of polythiophene poly(3,4-ethylenedioxythipohene) (PEDOT)

13. A method according to claim 1,
**characterized by** the second printing ink comprising an organic ferroelectric material.

14. A method according to claim 13.
**characterized by** selecting the organic ferroelectric material as one of an oligomer, copolymer, or terpolymer, or a blend or composites thereof.

15. A method according to claim 14.
**characterized by** selecting the organic ferroelectric material as a copolymer of polyvinylidene fluoride and trifluoroethylene (P(VDF-TrFE)).

16. A method according to claim 1,
**characterized by** providing an unpatterned functional interlayer between at least the first electrode layer and the memory layer.

17. A method according to claim 16,
**characterized by** selecting the functional interlayer as made of one of metals, metal oxides, organic high epsilon materials, or conducing polymers, or combinations thereof.

18. A method according to claim 17,
**characterized by** selecting the conducting polymer as PEDOT.

19. A method according to claim 16,
**characterized by** applying a fourth printing ink comprising a functional interlayer material to a printing means and applying the printing means to the first electrode layer printed in step a) and printing a functional interlayer onto the first electrode layer.

20. A method according to claim 19,
**characterized by** applying the fourth printing ink to a printing means and applying the printing means subsequent to the memory layer printed in step b) and printing a functional interlayer onto the memory layer.

21. A method according to claim 1,
**characterized by** repeating steps b) and c) at least once, whereby a stacked memory device is realized in the second electrode layer forms the first electrodes layer of a succeeding memory layer and so on.

## Patentansprüche

1. Verfahren zur Herstellung einer ferroelektrischen Speichervorrichtung, wobei die Speichereinrichtung eine Anordnung von ferroelektrischen Speicherzellen festgelegt in einer strukturierten oder unstrukturierten Schicht eines dünnen Films eines ferroelektrischen Polymers und erste und zweite Elektrodensätze solcher Art umfasst, dass die ferroelektrische Schicht von gegenüberliegenden Seiten dieser kontaktiert wird, so dass die ferroelektrische Speicherzelle in dem Speichermaterial zwischen der Kreuzung einer Elektrode des ersten Satzes mit einer Elektrode des zweiten Satzes festgelegt ist, wobei ein Polarisationszustand der Speicherzelle eingestellt werden kann, ein eingestellter Polarisationszustand umgeschaltet und durch Anlegen geeigneter Spannungen auf die die Speicherzelle kontaktierenden Elektroden, detektiert werden kann, wobei die Speichervorrichtung auf einem isolierenden Substrat vorgesehen ist und wobei das Verfahren **dadurch gekennzeichnet ist, dass**
es aufeinanderfolgende Schritte umfasst zum
a) Anwenden einer ersten Druckeinrichtung auf das Substrat, um eine erste Elektrodenschicht mit einer ersten Drucktinte darauf zu drucken, wobei der erste Elektrodensatz gebildet wird,
b) Anwenden einer zweiten Druckeinrichtung auf die erste Elektrodenschicht, und Drucken einer strukturierten oder unstrukturierten Schicht aus Speichermaterial mit einer zweiten Drucktinte und
c) Anwenden einer dritten Druckeinrichtung auf die Speicherschicht, um eine strukturierte, zweite Elektrodenschicht mit einer dritten Drucktinte darauf zu drucken, wobei der zweite Elektrodensatz gebildet wird, und wobei das Drucken in einem oder mehreren der Schritte a), b) und c) mit Tintenstrahldruck, Tiefdruck, Siebdruck, Flexogrammdruck, Offsetdruck, Stempeldruck, Rakeltiefdruck, Elektrograhiedruck, Weichlithographie, Wachsstrahldruck oder jedem anderen thermischen oder laserinduzierten Druckverfahren einzeln oder in Kombination durchgeführt wird.

2. Verfahren gemäß Anspruch 1, **dadurch gekennzeichnet, dass** die gleichen Druckeinrichtungen in zwei oder mehr der Schritte a) - c) verwendet werden.

3. Verfahren gemäß Anspruch 1, **dadurch gekennzeichnet, dass** unterschiedliche Druckeinrichtungen in jedem der Schritte a) - c) verwendet werden.

4. Verfahren gemäß Anspruch 1, **dadurch gekennzeichnet, dass** identische Drucktinten als erste und dritte Drucktinte verwendet werden.

5. Verfahren gemäß Anspruch 1, **dadurch gekennzeichnet, dass** die Drucktinten gemäß den gewählten Druckverfahren ausgesucht werden.

6. Verfahren gemäß Anspruch 1, **dadurch gekennzeichnet, dass** die Drucktinte entweder auf die zu bedruckende Oberfläche oder auf die Druckeinrichtung bevor, während oder nach der Anwendung der Druckeinrichtung auf diese Oberfläche aufgetragen wird, wobei die Anwendungsreihenfolge von dem gewählten Druckverfahren abhängig ist.

7. Verfahren gemäß Anspruch 1, **dadurch gekennzeichnet, dass** die ersten und dritten Drucktinten ein leitfähiges Material enthalten.

8. Verfahren gemäß Anspruch 7, **dadurch gekennzeichnet, dass** als leitfähiges Material ein anorganisches, leitfähiges Material gewählt wird.

9. Verfahren gemäß Anspruch 7, **dadurch gekennzeichnet, dass** als leitfähiges Material ein organisches, leitfähiges Material gewählt wird.

10. Verfahren gemäß Anspruch 9, **dadurch gekennzeichnet, dass** als organisches leitfähiges Material ein leitfähiges Polymer gewählt wird.

11. Verfahren gemäß Anspruch 10, **dadurch gekennzeichnet, dass** als leitfähiges Polymer Polypyrrol (PPy), Derivate von Polypyrrol, Polyanilin, Derivate von Polyanilin, Polythiophene und Derivate von Polythiophenen, entweder allein oder in Kombination gewählt wird.

12. Verfahren gemäß Anspruch 11, **dadurch gekennzeichnet, dass** als Polythiophenderivat Poly(3,4-ethylendioxythiophen)(PEDOT) gewählt wird.

13. Verfahren gemäß Anspruch 1, **dadurch gekennzeichnet, dass** die zweite Drucktinte ein ferroelektrisches, organisches Material enthält.

14. Verfahren gemäß Anspruch 13, **dadurch gekennzeichnet, dass** als ferroelektrisches, organisches Material ein Oligomer, Copolymer oder Terpolymer oder eine Mischung oder ein Verbundwerkstoff daraus, gewählt wird.

15. Verfahren gemäß Anspruch 14, **dadurch gekennzeichnet, dass** als ferroelektrisches, organisches Material ein Copolymer aus Polyvinylidenfluorid und Trifluorethylen (P(VDF-TrFE)) gewählt wird.

16. Verfahren gemäß Anspruch 1, **gekennzeichnet durch** das Bereitstellen einer unstrukturierten funktionalen Zwischenschicht zwischen wenigstens der ersten Elektrodenschicht und der Speicherschicht.

17. Verfahren gemäß Anspruch 16, **gekennzeichnet durch** Auswahl der funktionalen Zwischenschicht so, dass sie aus Metallen, Metalloxiden, organischen "high-epsilon"-Materialien oder leitfähigen Polymeren oder Kombinationen von diesen hergestellt ist.

18. Verfahren gemäß Anspruch 17, **dadurch gekennzeichnet, dass** als leitfähiges Polymer PEDOT gewählt wird.

19. Verfahren gemäß Anspruch 16, **gekennzeichnet durch** Auftragen einer vierten Drucktinte, enthaltend ein funktionales Zwischenschichtmaterial, auf ein Druckmittel und Anwenden des Druckmittels auf die in Schritt a) gedruckte erste Elektrodenschicht und Drucken einer funktionalen Zwischenschicht auf die erste Elektrodenschicht.

20. Verfahren gemäß Anspruch 19, **gekennzeichnet durch** Auftragen der vierten Drucktinte auf ein Druckmittel und Anwenden des Druckmittels anschließend an die in Schritt b) gedruckte Speicherschicht und Drucken einer funktionalen Zwischenschicht auf die Speicherschicht.

21. Verfahren gemäß Anspruch 1, **gekennzeichnet durch** zumindest einmaliges Wiederholen der Schritte b) und c), wobei eine geschichtete Speichervorrichtung erhalten wird, indem die zweite Elektrodenschicht die erste Elektrode einer darauffolgenden Speicherschicht bildet usw.

## Revendications

1. Procédé de fabrication d'un dispositif de mémoire ferroélectrique, dans lequel le dispositif de mémoire comprend un réseau de cellules de mémoire ferroélectrique défini dans une couche à motif ou sans motif d'un film mince d'un polymère ferroélectrique, et des premier et deuxième ensembles d'électrodes disposés de sorte à être en contact avec la couche ferroélectrique de côtés opposés de celle-ci, de sorte que la cellule de mémoire ferroélectrique est définie dans le matériau de mémoire entre le croisement d'une électrode du premier ensemble avec une électrode du deuxième ensemble, un état de polarisation de la cellule de mémoire pouvant ainsi être établi, des états de polarisation d'ensemble étant commutés et détectés par application de tensions appropriées aux électrodes en contact avec la cellule de mémoire, où le dispositif de mémoire est prévu sur un substrat isolant, et où le procédé est **caractérisé en ce qu'**il comprend les étapes successives consistant à
a) appliquer un premier moyen d'impression sur le substrat pour imprimer une première couche d'électrode sur celui-ci avec une première encre d'impression, le premier ensemble d'électrodes étant ainsi formé,
b) appliquer un deuxième moyen d'impression sur la première couche d'électrode et imprimer sur celle-ci une couche à motif ou sans motif de matériau à mémoire avec une deuxième encre d'impression, et
c) appliquer un troisième moyen d'impression sur la couche de mémoire pour imprimer sur celle-ci une deuxième couche d'électrode à motif avec une troisième encre d'impression, le deuxième ensemble d'électrodes étant ainsi formé et l'impression dans une ou plus des étapes a), b) et c) étant ainsi effectuée par imprimante jet d'encre, impression en creux, sérigraphie, impression flexographique, impression offset, impression estampée, héliogravure, impression électrographique, lithographie molle, impression jet de cire ou tout procédé d'impression thermique ou laser, séparément ou en combinaison.

2. Procédé selon la revendication 1,
**caractérisé par** l'utilisation du même moyen d'impression dans deux ou plus des étapes a) à c).

3. Procédé selon la revendication 1,
**caractérisé par** l'utilisation de moyens d'impression différents dans chacune des étapes a) à c).

4. Procédé selon la revendication 1,
**caractérisé par** l'application d'encres d'impression identiques en tant que première et troisième encre d'impression.

5. Procédé selon la revendication 1,
**caractérisé par** une sélection des encres d'impression selon un procédé d'impression choisi.

6. Procédé selon la revendication 1,
**caractérisé par** l'application de l'encre d'impression soit sur la surface à imprimer, soit sur le moyen d'impression avant, pendant ou après l'application du moyen d'impression sur ladite surface, la séquence d'application étant dépendante d'un procédé d'impression choisi.

7. Procédé selon la revendication 1,
**caractérisé en ce que** les première et troisième encres d'impression comprennent un matériau conducteur.

8. Procédé selon la revendication 7,
**caractérisé par** la sélection du matériau conducteur en tant que matériau conducteur inorganique.

9. Procédé selon la revendication 7,
**caractérisé par** la sélection du matériau conducteur en tant que matériau organique conducteur.

10. Procédé selon la revendication 9,
**caractérisé par** la sélection du matériau organique conducteur en tant que polymère conducteur.

11. Procédé selon la revendication 10,
**caractérisé par** la sélection du polymère conducteur en tant qu'un élément parmi le poly(pyrrole) (PPy), les dérivés du poly(pyrrole), la poly(aniline), les dérivés de poly(aniline), les poly(thiophènes) et les dérivés de poly(thiophènes), séparément ou en combinaison.

12. Procédé selon la revendication 11,
**caractérisé par** la sélection en tant que dérivé de poly(thiophène), du poly(3,4-éthylènedioxythiophène) (PEDOT).

13. Procédé selon la revendication 1,
**caractérisé en ce que** la deuxième encre d'impression comprend un matériau ferroélectrique organique.

14. Procédé selon la revendication 13,
**caractérisé par** la sélection du matériau ferroélectrique organique en tant qu'un élément parmi un oligomère, un copolymère ou un terpolymère, ou un mélange ou des composites de ceux-ci.

15. Procédé selon la revendication 14,
**caractérisé par** la sélection du matériau ferroélectrique organique en tant que copolymère de poly(fluorure de vinylidène) et de trifluoroéthylène (P(VDF-TrFE)).

16. Procédé selon la revendication 1,
**caractérisé par** la disposition d'une intercouche fonctionnelle sans motif entre au moins la première couche d'électrode et la couche de mémoire.

17. Procédé selon la revendication 16,
**caractérisé par** la sélection de l'intercouche fonctionnelle comme étant constituée d'un élément parmi les métaux, les oxydes de métaux, les matériaux organiques à degré epsilon élevé, ou les polymères conducteurs, ou des combinaisons de ceux-ci.

18. Procédé selon la revendication 17,
**caractérisé par** la sélection du polymère conducteur en tant que PEDOT.

19. Procédé selon la revendication 16,
**caractérisé par** l'application d'une quatrième encre d'impression comprenant un matériau d'intercouche fonctionnel sur un moyen d'impression et l'application du moyen d'impression sur la première couche d'électrode imprimée à l'étape a), et l'impression d'une intercouche fonctionnelle sur la première couche d'électrode.

20. Procédé selon la revendication 19,
**caractérisé par** l'application de la quatrième encre d'impression sur un moyen d'impression et l'application du moyen d'impression après l'impression de la couche de mémoire à l'étape b) et l'impression d'une intercouche fonctionnelle sur la couche de mémoire.

21. Procédé selon la revendication 1,
**caractérisé par** la répétition des étapes b) et c) au moins une fois, un dispositif de mémoire empilé étant ainsi réalisé dans lequel la deuxième couche d'électrode forme la première couche d'électrode d'une couche de mémoire suivante, et ainsi de suite.
